# EUROPEAN PATENT APPLICATION

(11) **EP 4 797 306 A1**
(43) Date of publication of application: **26.08.2026**
(21) Application number: 25846583.0
(22) Date of filing: 19.05.2025
(51) Int. Cl.: H01H 13/705, H01H 13/7065, H03K 17/90

(54) **KEY STRUCTURE AND HALL SWITCH**

(30) Priority: 02.08.2024 CN 202411058572; 02.08.2024 CN 202421875354 U
(71) Applicant: Shanghai Flydigi Electronics Technology Co., Ltd., Shanghai 200000 (CN)
(72) Inventor: FAN, Wen, Shanghai 200000 (CN); ZHANG, Yawu, Shanghai 200000 (CN); HUANG, Wei, Shanghai 200000 (CN); SUN, Jinxin, Shanghai 200000 (CN)
(74) Representative: Osterhoff, Utz
(86) International application number: PCT/CN2025/095735
(87) International publication number: WO 2026/026137

(57) **Abstract**

The present application provides a button structure and a Hall switch. The button structure includes a housing, a stem, a magnetic member, a shaft cap, and a reset member, the housing is provided with a guide channel; the stem is slidably installed in the guide channel, and one end of the stem is provided with a connection portion; the magnetic member is connected to the stem; the shaft cap is slidably mounted on the housing, the shaft cap is provided with a mating portion, the connection portion and the mating portion abut against each other in an axial direction of the stem, and a clearance gap is formed between the connection portion and the mating portion such that when the shaft cap deflects with respect to the housing, the stem remains stationary with respect to the housing; and the reset member is mounted on the housing and is configured to reset the stem. The Hall switch includes a circuit board and the button structure described above, the circuit board is provided on a side of the housing distant from the shaft cap, and the circuit board is provided with a Hall element.

## Description

### RELATED APPLICATIONS

This application claims priority to Chinese Patent Application No. 202411058572.5 and Chinese Patent Application No. 202421875354.6, both filed on August 2, 2024, the entire contents of which are incorporated herein by reference.

### TECHNICAL FIELD

The present application relates to the technical field of keyboards, and in particular to a button structure and a Hall switch.

### BACKGROUND

At present, a keyboard, as an input device, is widely used in work and game entertainment. Among various types of keyboards, a mechanical keyboard is one type. A main difference between the mechanical keyboard and other keyboards lies in a button structure. The button structure mainly includes a housing, a stem, and a keycap, the stem is slidably installed in a guide channel of the housing, a reset spring is connected between the stem and the housing, a user presses the keycap such that the stem moves downward, and a magnetic member installed on the stem triggers a Hall element on a circuit board, thereby generating an input signal.

However, in the button structure of the existing mechanical keyboard, in order to ensure smooth sliding of the stem, an assembly clearance is usually reserved between the stem and the guide channel of the housing, such that when the keycap is subjected to a lateral force, the stem and the magnetic member are driven to shake, causing a change in a magnetic field around the Hall element, thereby resulting in a risk that the magnetic member falsely triggers the Hall element. Especially for a keyboard in which the Hall element is arranged at a side of the magnetic member, shaking of the stem in a horizontal direction has a great influence on signal acquisition accuracy of the Hall element, and the risk of false triggering is higher.

### SUMMARY

A main objective of the present application is to provide a button structure, aiming to improve stability of the stem.

In order to achieve the above objective, the present application provides a button structure, which includes:
a housing provided with a guide channel;
a stem slidably installed in the guide channel, where one end of the stem is provided with a connection portion;
a magnetic member connected to the stem;
a shaft cap slidably mounted on the housing, where the shaft cap is provided with a mating portion, the connection portion and the mating portion abut against each other in an axial direction of the stem, and a clearance gap is formed between the connection portion and the mating portion such that when the shaft cap deflects with respect to the housing, the stem remains stationary with respect to the housing; and
a reset member mounted on the housing and configured to reset the stem.

In some embodiments of the present application, the shaft cap is provided with the mating portion on a side facing the stem, the connection portion is an end surface of the stem adjacent to the shaft cap, a middle of the mating portion abuts against the connection portion, and the clearance gap is formed between a periphery of the mating portion and the mating portion.

In some embodiments of the present application, the mating portion is a spherical protrusion, the connection portion is an abutment plane, and the abutment plane abuts against a spherical surface of the spherical protrusion.

In some embodiments of the present application, an end surface of the shaft cap adjacent to the stem is provided with an assembly groove, the mating portion is provided on a bottom wall of the assembly groove, and an end of the stem adjacent to the shaft cap is in clearance fit with the assembly groove.

In some embodiments of the present application, a flange is provided on a periphery of one end of the stem adjacent to the shaft cap, and the flange is in clearance fit with the assembly groove; and
the reset member is a reset spring sleeved outside the stem, and two ends of the reset spring respectively abut against the flange and the housing.

In some embodiments of the present application, the housing includes an outer shell and a guide portion, the outer shell is provided with an installation cavity, the guide portion is connected to a cavity wall of the installation cavity, the guide channel is formed in the guide portion, and the guide portion is sleeved between the reset spring and the stem.

In some embodiments of the present application, the outer shell is provided with a limiting portion, the shaft cap is provided with a positioning portion, and the positioning portion is slidably limited to the limiting portion.

In some embodiments of the present application, the button structure further includes a keycap, and the keycap is connected to an end of the shaft cap distant from the stem.

In some embodiments of the present application, an end surface of the stem distant from the shaft cap is provided with an installation groove, and the magnetic member is installed in the installation groove.

The present application further provides a Hall switch, including a circuit board and the above button structure; the button structure includes:
a housing provided with a guide channel;
a stem slidably installed in the guide channel, where one end of the stem is provided with a connection portion;
a magnetic member connected to the stem;
a shaft cap slidably mounted on the housing, where the shaft cap is provided with a mating portion, the connection portion and the mating portion abut against each other in an axial direction of the stem, and a clearance gap is formed between the connection portion and the mating portion such that when the shaft cap deflects with respect to the housing, the stem remains stationary with respect to the housing; and
a reset member mounted on the housing and configured to reset the stem.

The circuit board is provided on a side of the housing distant from the shaft cap, and the circuit board is provided with a Hall element.

In the technical solution of the present application, when the shaft cap is pressed, the mating portion presses against the connection portion, such that the stem moves along the axial direction and drives the magnetic member to move close to the circuit board, the Hall element senses a change of a surrounding magnetic field and generates an input signal, and after the pressing force is removed, the stem is reset under the action of the reset member.

The stem cooperates with the mating portion of the shaft cap through the connection portion, and the clearance gap is formed between the connection portion and the mating portion, such that when the shaft cap is subjected to a lateral force, the shaft cap deflects with respect to the housing, one of the connection portion and the mating portion retreats into the clearance gap, and the stem remains stationary with respect to the housing, thereby effectively avoiding a problem that the magnetic member shakes to falsely trigger the Hall element, and achieving better stability.

### BRIEF DESCRIPTION OF THE DRAWINGS

To more clearly illustrate the technical solutions in the embodiments of this application or the prior art, the drawings used in the description of the embodiments or the prior art will be briefly introduced below. Obviously, the drawings described below are only some embodiments of this application. For those skilled in the art, other drawings can be obtained based on the structures shown in these drawings without creative effort.
FIG. 1 is a schematic structural view of a Hall switch according to an embodiment of the present application.
FIG. 2 is an exploded structural view of the Hall switch according to an embodiment of the present application.
FIG. 3 is an exploded structural view of a button structure according to an embodiment of the present application.
FIG. 4 is a cross-sectional view of a button structure according to an embodiment of the present application.

### Description of reference signs:

100, button structure; 10, housing; 101, guide channel; 11, outer shell; 111, installation cavity; 112, limiting portion; 12, guide portion; 20, stem; 21, connection portion; 211, abutment plane; 22, flange; 23, installation groove; 30, magnetic member; 40, shaft cap; 41, mating portion; 411, spherical protrusion; 42, assembly groove; 43, positioning portion; 45, clearance gap; 50, reset member; 60, keycap; 200, circuit board; 210, Hall element; 300, protective shell; 1000, Hall switch.

The objectives, technical features, and advantages of the present application will be further described below with reference to the embodiments and the accompanying drawings.

### DETAILED DESCRIPTION OF THE EMBODIMENTS

The technical solutions of the embodiments of the present application will be clearly and completely described below with reference to the drawings of the embodiments of the present application. It is apparent that the described embodiments are only part of the embodiments of the present application, rather than all of the embodiments. Based on the embodiments in the present application, all other embodiments obtained by those of ordinary skill in the art without creative efforts fall within the protection scope of the present application.

It should be noted that, if directional indications (such as up, down, left, right, front, rear, etc.) are involved in the embodiments of the present application, the directional indications are merely used for explaining relative positional relationships, movement conditions and the like between components under a certain specific posture. When the specific posture is changed, the directional indications are correspondingly changed.

In addition, if descriptions such as "first" and "second" are involved in the embodiments of the present application, the descriptions of "first" and "second" are merely used for descriptive purposes, and should not be construed as indicating or implying their relative importance or implicitly specifying the number of indicated technical features. Therefore, features defined as "first" or "second" may explicitly or implicitly include at least one of such features. In addition, if "and/or" or "and/or" appears throughout the specification, it refers to three parallel alternatives. For example, "A and/or B" includes a case of A alone, or B alone, or both A and B simultaneously. Furthermore, the technical solutions among the embodiments can be combined with each other, but such combinations must be based on the capability of those skilled in the art to implement them. When the combination of the technical solutions results in mutual contradictions or is technically unfeasible, it should be considered that such combinations do not exist and are not within the protection scope of the present application.

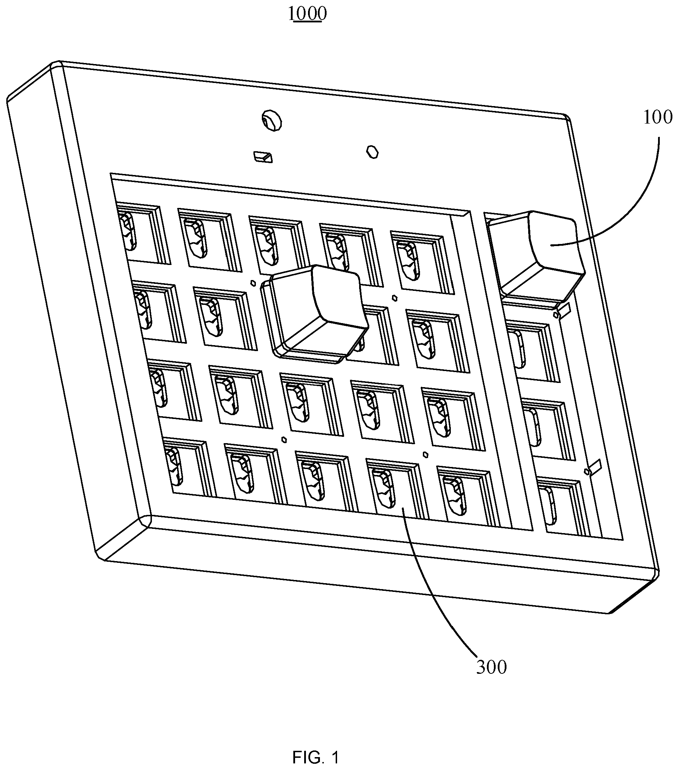

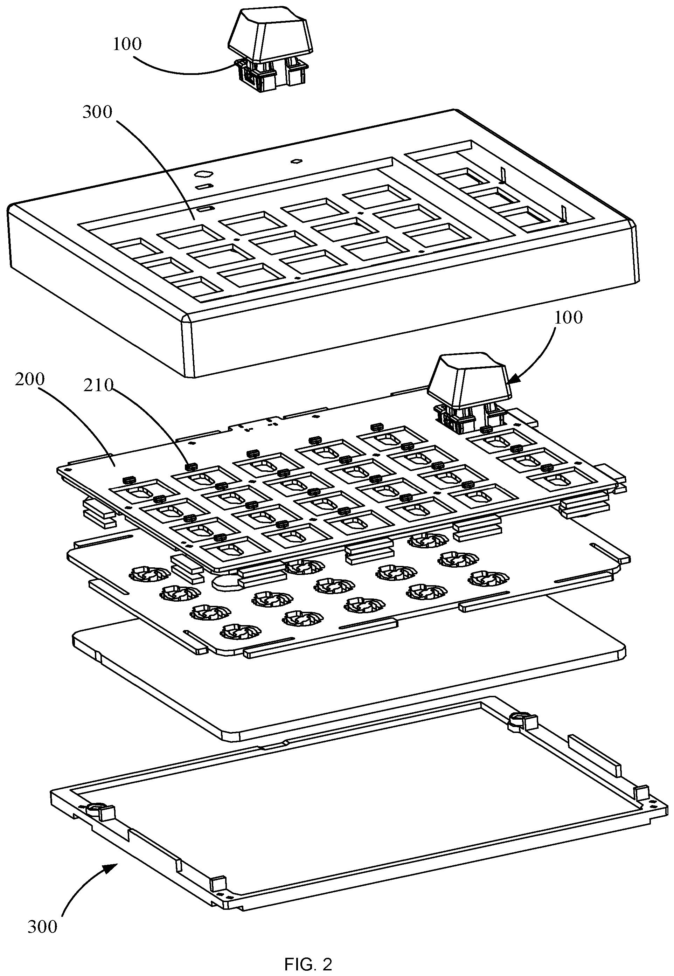

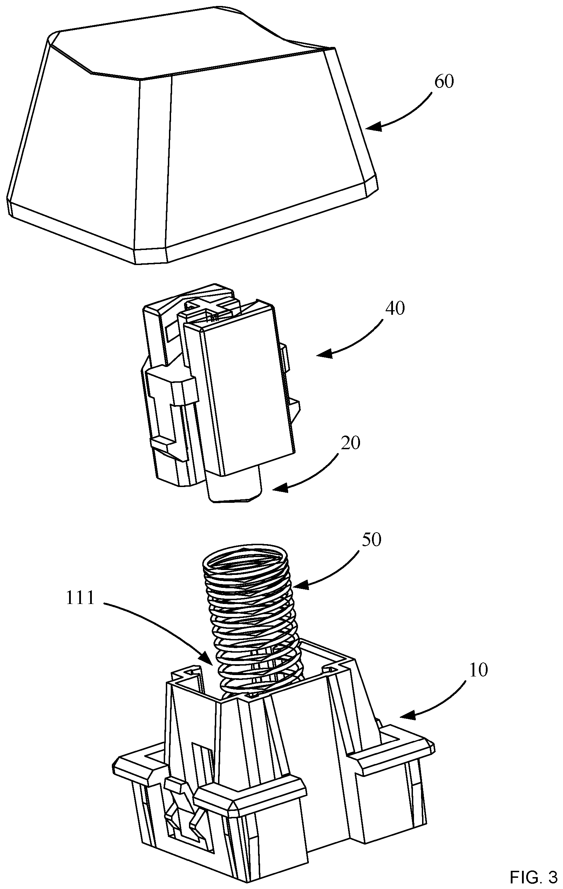

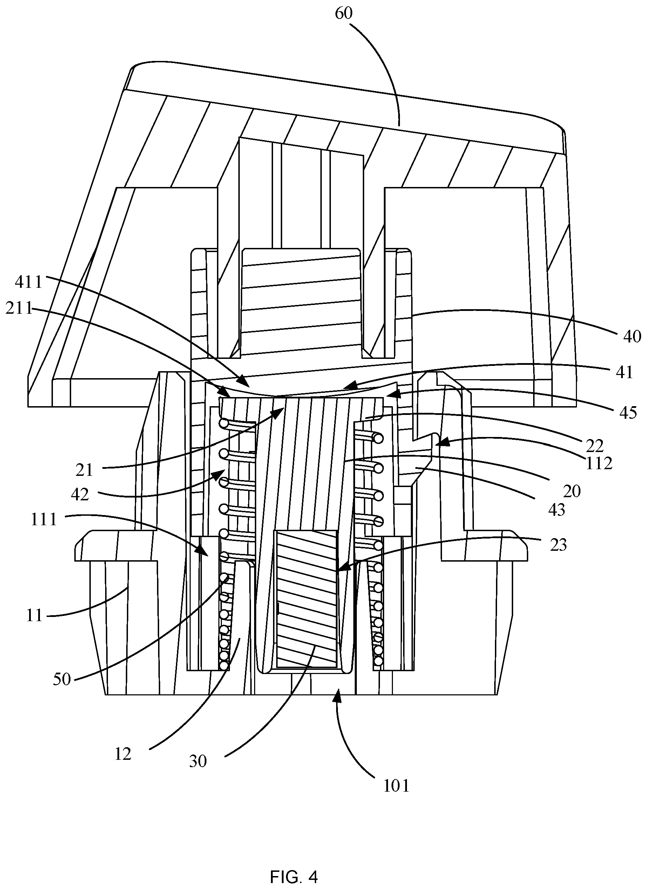

Referring to FIG. 1 to FIG. 4, the present application provides a button structure 100, which includes a housing 10, a stem 20, a magnetic member 30, a shaft cap 40, and a reset member 50, the housing 10 is provided with a guide channel 101; the stem 20 is slidably installed in the guide channel 101, and one end of the stem 20 is provided with a connection portion 21; the magnetic member 30 is connected to the stem 20; the shaft cap 40 is slidably mounted on the housing 10, the shaft cap 40 is provided with a mating portion 41, the connection portion 21 and the mating portion 41 abut against each other in an axial direction of the stem 20, and a clearance gap 45 is formed between the connection portion 21 and the mating portion 41 such that when the shaft cap 40 deflects with respect to the housing 10, the stem 20 remains stationary with respect to the housing 10; and the reset member 50 is mounted on the housing 10 and is configured to reset the stem 20.

In the technical solution of the present application, when the shaft cap 40 is pressed, the mating portion 41 presses against the connection portion 21, such that the stem 20 moves along the axial direction and drives the magnetic member 30 to move close to a circuit board 200, a Hall element 210 senses a change of a surrounding magnetic field and generates an input signal, and after the pressing force is removed, the stem 20 is reset under the action of the reset member 50.

The stem 20 cooperates with the mating portion 41 of the shaft cap 40 through the connection portion 21, and the clearance gap 45 is formed between the connection portion 21 and the mating portion 41, such that when the shaft cap 40 is subjected to a lateral force, the shaft cap 40 deflects with respect to the housing 10, one of the connection portion 21 and the mating portion 41 retreats into the clearance gap 45, or the clearance space between the connection portion 21 and the mating portion 41 is wholly or partially reduced, such that the stem 20 remains stationary with respect to the housing 10, thereby effectively avoiding a problem that the magnetic member 30 shakes to falsely trigger the Hall element 210, and achieving better stability.

The stem 20 and the shaft cap 40 described above have various implementations. In an embodiment, one end surface of the shaft cap 40 is provided with an assembly groove 42, an inner peripheral wall of the assembly groove 42 is provided with four elongated holes to form the mating portion 41, the four elongated holes are arranged at equal intervals around the assembly groove 42, a length direction of each elongated hole is the same as an axial direction of the stem 20, one end of the stem 20 is provided with four guide posts protruding from a periphery to form the connection portion 21, the four guide posts are arranged at equal intervals around the stem 20, one guide post is assembled in one elongated hole and is capable of sliding along the length direction of the elongated hole, and the clearance gap 45 is formed between a hole wall of the elongated hole and the guide post.

Through the above solution, when the keycap 60 is not affected by an external force, a hole wall of each elongated hole close to a top side in the keycap 60 abuts against the guide post; when the keycap 60 is subjected to a vertical pressure, the hole wall of the elongated hole abuts against the guide post, such that the stem 20 moves downward; when the keycap 60 is subjected to a lateral pressure, a top-side hole wall of the elongated hole on a pressed side of the keycap 60 tilts upward, the guide post moves into the clearance gap 45, and the stem 20 remains stationary with respect to the housing 10.

In some other embodiments of the present application, the shaft cap 40 is provided with the mating portion 41 on a side facing the stem 20, the connection portion 21 is an end surface of the stem 20 facing the shaft cap 40, a middle of the mating portion 41 abuts against the connection portion 21, and the clearance gap 45 is formed between a periphery of the mating portion 41 and the mating portion 41.

In this way, the mating portion 41 abuts against the connection portion 21 only through a central portion, and the clearance gap 45 is formed between the periphery of the mating portion 41 and the mating portion 41, such that when the shaft cap 40 deflects laterally, the shaft cap 40 does not drive the stem 20, thereby ensuring stability of the stem 20.

The mating portion 41 and the connection portion 21 described above have various implementations. In an embodiment, the mating portion 41 is a conical protrusion, the connection portion 21 is provided as a plane, and a vertex of the conical protrusion abuts against the connection portion 21.

In some other embodiments of the present application, the mating portion 41 is a spherical protrusion 411, the connection portion 21 is an abutment plane 211, and the abutment plane 211 abuts against a spherical surface of the spherical protrusion 411. In this way, when the shaft cap 40 is subjected to a lateral force and shakes, the shaking is relatively smooth, and the spherical protrusion 411 has a strong capability of resisting deformation under high-frequency pressing, which is beneficial to prolonging a service life of the button.

In some embodiments of the present application, the shaft cap 40 and the stem 20 are slidably installed in the guide channel 101 together. In some other embodiments of the present application, an end surface of the shaft cap 40 adjacent to the stem 20 is provided with an assembly groove 42, the mating portion 41 is provided on a bottom wall of the assembly groove 42, and an end of the stem 20 adjacent to the shaft cap 40 is in clearance fit with the assembly groove 42. In this way, a structure is more compact.

The reset member 50 generally adopts a reset spring, which has a good reset effect, a fast response speed, and a long service life. In some embodiments of the present application, a flange 22 is provided on a periphery of one end of the stem 20 adjacent to the shaft cap 40, and the flange 22 is in clearance fit with the assembly groove 42; the reset member 50 is a reset spring sleeved outside the stem 20, and two ends of the reset spring respectively abut against the flange 22 and the housing 10. In this way, when the shaft cap 40 is pressed, the shaft cap 40 abuts against the stem 20, the reset spring is pressed by the flange 22 and is compressed, and after the pressing force applied to the shaft cap 40 is removed, the reset spring abuts against the flange 22 and drives the stem 20 to push the shaft cap 40 to reset together.

In some embodiments of the present application, the housing 10 includes an outer shell 11 and a guide portion 12, the outer shell 11 is provided with an installation cavity 111, the guide portion 12 is connected to a cavity wall of the installation cavity 111, the guide channel 101 is formed in the guide portion 12, and the guide portion 12 is sleeved between the reset spring and the stem 20. In this solution, the guide portion 12 is used not only for guiding the stem 20, but also for positioning the reset spring, the housing 10 does not need to be provided with an additional positioning structure, a structural complexity and a processing cost are reduced, and a structural compactness is improved.

A size of a clearance between the flange 22 and the assembly groove 42 needs to be set in proportion to a maximum offset amount of the shaft cap 40 in the installation cavity 111, and similarly, a size of the clearance gap 45 between the spherical protrusion 411 and the abutment plane 211 also needs to be set in proportion to the maximum offset amount of the shaft cap 40 in the installation cavity 111, so as to ensure that when the shaft cap 40 is offset to a maximum angle, the shaft cap 40 still does not affect the stem 20, and the size of the clearance is set according to specific conditions and is not further limited herein.

The shaft cap 40 is limited by the stem 20 and the reset member 50, or is limited by the housing 10. In some embodiments of the present application, the outer shell 11 is provided with a limiting portion 112, the shaft cap 40 is provided with a positioning portion 43, and the positioning portion 43 is slidably limited to the limiting portion 112. The structures of the positioning portion 43 and the limiting portion 112 are various. The positioning portion 43 may be a hook or a protrusion, and the limiting portion 112 may be a slot or a hole.

In some embodiments of the present application, the button structure 100 further includes a keycap 60, and the keycap 60 is connected to an end of the shaft cap 40 distant from the stem 20, so as to facilitate a pressing operation by a user.

The magnetic member 30 is generally installed at an end of the stem 20 distant from the shaft cap 40, and may be installed on an end surface or on a side surface. In some embodiments of the present application, an end surface of the stem 20 distant from the shaft cap 40 is provided with an installation groove 23, and the magnetic member 30 is installed in the installation groove 23. In this way, assembly is facilitated, an assembly efficiency is improved, and an assembly cost is reduced.

The present application further provides a Hall switch 1000, which includes a circuit board 200 and the button structure 100 described above, the circuit board 200 is provided on a side of the housing 10 distant from the shaft cap 40, and the circuit board 200 is provided with a Hall element 210. When the Hall switch 1000 is a keyboard, a plurality of button structures 100 are provided, the circuit board 200 is integrated with a plurality of Hall elements 210, and each Hall element 210 is opposite to each button structure 100.

The foregoing description is merely exemplary embodiments of the present application and is not intended to limit the protection scope of the present application. Any equivalent structural changes made under the technical concept of the present application by using the contents of the specification and the drawings of the present application, or any direct or indirect application of the technical solutions to other related technical fields, fall within the protection scope of the present application.

## Claims

1. A button structure (100), **characterized by** comprising:
a housing (10) provided with a guide channel (101);
a stem (20) slidably installed in the guide channel (101), wherein one end of the stem (20) is provided with a connection portion (21);
a magnetic member (30) connected to the stem (20);
a shaft cap (40) slidably mounted on the housing (10), wherein the shaft cap (40) is provided with a mating portion (41), the connection portion (21) and the mating portion (41) abut against each other in an axial direction of the stem (20), a clearance gap (45) is formed between the connection portion (21) and the mating portion (41), and when the shaft cap (40) deflects with respect to the housing (10), the stem (20) remains stationary with respect to the housing (10); and
a reset member (50) mounted on the housing (10) and configured to reset the stem (20).

2. The button structure (100) according to claim 1, wherein the shaft cap (40) is provided with the mating portion (41) on a side facing the stem (20), the connection portion (21) is an end surface of the stem (20) adjacent to the shaft cap (40), a middle of the mating portion (41) abuts against the connection portion (21), and the clearance gap (45) is formed between a periphery of the mating portion (41) and the mating portion (41).

3. The button structure (100) according to claim 2, wherein the mating portion (41) is a spherical protrusion (411), the connection portion (21) is an abutment plane (211), and the abutment plane (211) abuts against a spherical surface of the spherical protrusion (411).

4. The button structure (100) according to claim 2, wherein an end surface of the shaft cap (40) adjacent to the stem (20) is provided with an assembly groove (42), the mating portion is provided on a bottom wall of the assembly groove (42), and an end of the stem (20) adjacent to the shaft cap (40) is in clearance fit with the assembly groove (42).

5. The button structure (100) according to claim 4, wherein a flange (22) is provided on a periphery of one end of the stem (20) adjacent to the shaft cap (40), and the flange (22) is in clearance fit with the assembly groove (42); and
the reset member (50) is a reset spring sleeved outside the stem (20), and two ends of the reset spring respectively abut against the flange (22) and the housing (10).

6. The button structure (100) according to claim 5, wherein the housing (10) comprises an outer shell (11) and a guide portion (12), the outer shell (11) is provided with an installation cavity (111), the guide portion (12) is connected to a cavity wall of the installation cavity (111), the guide channel (101) is formed in the guide portion (12), and the guide portion (12) is sleeved between the reset spring and the stem (20).

7. The button structure (100) according to claim 6, wherein the outer shell (11) is provided with a limiting portion (112), the shaft cap (40) is provided with a positioning portion (43), and the positioning portion (43) is slidably limited to the limiting portion (112).

8. The button structure (100) according to any one of claims 1 to 7, wherein the button structure (100) further comprises a keycap (60), and the keycap (60) is connected to an end of the shaft cap (40) distant from the stem (20).

9. The button structure (100) according to any one of claims 1 to 7, wherein an end surface of the stem (20) distant from the shaft cap (40) is provided with an installation groove (23), and the magnetic member (30) is installed in the installation groove (23).

10. A Hall switch (1000), **characterized by** comprising a circuit board (200) and the button structure (100) according to any one of claims 1 to 9,
wherein the circuit board (200) is provided on a side of the housing (10) distant from the shaft cap (40), and the circuit board (200) is provided with a Hall element (210).
